# EUROPÄISCHE PATENTSCHRIFT

(11) **EP 2 008 344 B1**
(45) Veröffentlichungstag und Bekanntmachung des Hinweises auf die Patenterteilung: **24.02.2010**
(21) Anmeldenummer: 07723435.9
(22) Anmeldetag: 20.03.2007
(51) Int. Cl.: H01R 13/658, H01R 13/74, H05K 9/00

(54) **Potentialfreie Gehäusedurchführung**
Potential-free housing penetration
Traversée sans potentiel dans un boîtier

(30) Priorität: 20.04.2006 DE 202006006359 U
(43) Veröffentlichungstag der Anmeldung: 31.12.2008
(73) Patentinhaber: Rosenberger Hochfrequenztechnik GmbH & Co. KG, 83413 Fridolfing (DE)
(72) Erfinder: WOLLITZER, Michael, 83413 Fridolfing (DE)
(74) Vertreter: Zeitler, Giselher
(86) Internationale Anmeldenummer: PCT/EP2007/002472
(87) Internationale Veröffentlichungsnummer: WO 2007/121813

(56) Entgegenhaltungen:
- WO-A-00/16344
- GB-A- 2 308 511

## Beschreibung

Die vorliegende Erfindung betrifft eine Schaltungsanordnung mit einer auf einer Leiterplatte angeordneten elektronischen Schaltung und einem die Leiterplatte umgebenden, abschirmenden Gehäuse, wobei auf der Leiterplatte ein mit der elektronischen Schaltung verbundener HF-Steckverbinder mit einem Außenleiterteil und einem Innenleiterteil angeordnet ist, wobei der HF-Steckverbinder durch eine Öffnung in dem Gehäuse hindurch greift, gemäß dem Oberbegriff des Anspruchs 1. (siehe zum Beispiel das Dokument WO-A-00/16 344)

Bei der Verbindung von zwei oder mehr in jeweils einem abschirmenden Gehäuse angeordneten, elektrischen Schaltungen über wenigstens ein Kabel mit einem Signalleiter und einer Abschirmung ist es bekannt, die Abschirmung des Kabels mit beiden oder allen Gehäusen elektrisch direkt zu verbinden, um eine ununterbrochen Abschirmung gegen den Austritt sowie den Eintritt von Hochfrequenzsignalen bzgl. der Signalleiter und den Gehäusen zu erzielen. Hierbei ergibt sich jedoch das Problem, dass durch die elektrisch leitende Verbindung der beiden oder aller Gehäuse über die Abschirmung des Kabels durch Potentialdifferenzen zwischen den Gehäusen ein unerwünschter Strom über die Abschirmung des Kabels fließt. Außerdem ist diese Anordnung dann nicht möglich, wenn die zu verbindenden elektrischen Schaltungen unterschiedliche Massepotentiale haben sollen, da dies unweigerlich zu einem parasitären Stromfluss auf der Abschirmung des Kabels führt. Die Massepotentiale der beiden zu verbindenden elektrischen Schaltungen können daher nicht unterschiedlich gehalten werden. In solchen Fällen ist es daher notwendig, dass die Abschirmung des Kabels nur mit einem der Gehäuse direkt elektrisch verbunden ist und bezüglich des bzw. der anderen Gehäuse elektrisch getrennt bzw. galvanisch kontaktfrei ist. Dies wirft jedoch das Problem auf, dass die Abschirmung notwendigerweise dort offen ist, wo das Kabel bzw. ein entsprechender mit der elektrischen Schaltung verbundener Kabel- bzw. Steckverbinder in ein Gehäuse führt, mit dem die Abschirmung des Kabels nicht verbunden ist.

Der Erfindung liegt die Aufgabe zugrunde, eine Schaltungsanordnung der o.g. Art mit potentialfreier Signalverbindung zu schaffen, die ein unerwünschtes Austreten von Hochfrequenzsignalen aus dem Signalleiter bzw. dem Gehäuse heraus sowie ebenfalls ein unerwünschtes Eintreten von äußeren Hochfrequenzsignalen in den Signalleiter bzw. das Gehäuse hinein wirksam verhindert.

Diese Aufgabe wird erfindungsgemäß durch eine Schaltungsanordnung der o.g. Art mit den in Anspruch 1 gekennzeichneten Merkmalen gelöst. Vorteilhafte Ausgestaltungen der Erfindung sind in den weiteren Ansprüchen beschrieben.

Bei einer Schaltungsanordnung der o.g. Art ist es erfindungsgemäß vorgesehen, dass das Außenleiterteil des HF-Steckverbinders von dem Gehäuse galvanisch getrennt ist, wobei eine das Außenleiterteil sowohl in axialer Richtung als auch in Umfangsrichtung wenigstens teilweise tunnelartig umgebende Abschirmhülse angeordnet ist, welche mit dem Gehäuse galvanisch und mit dem Außenleiterteil des HF-Steckverbinders kapazitiv verbunden ist.

Dies hat den Vorteil, dass trotz der mechanisch offenen Abschirmung im Bereich des Durchgriffes des HF-Steckverbinders durch das Gehäuse eine Ein- sowie Auskopplung von HF-Signalen unterbunden ist, da diese Signale über die kapazitive Ankopplung des Außenleiterteiles an das Gehäuse kurzgeschlossen sind und Moden höherer Ordnung in der tunnelartigen Abschirmhülse exponentiell abklingen.

Zweckmäßigerweise weist die Leiterplatte eine Systemmasse auf, die von dem Gehäuse galvanisch getrennt ist.

Zur Signalübertragung von dem Innenleiterteil zur elektronischen Schaltung auf der Leiterplatte ist das Innenleiterteil mit wenigstens einer Signalleiterbahn der elektronischen Schaltung auf der Leiterplatte galvanisch oder kapazitiv verbunden.

In einer bevorzugten Ausführungsform umfasst die kapazitive Verbindung zwischen der Abschirmhülse und dem Außenleiterteil des HF-Steckverbinders mehrere Kondensatoren, die beabstandet voneinander jeweils einerseits mit der Abschirmhülse und andererseits mit dem Außenleiterteil des HF-Steckverbinders verbunden sind.

Zum Übertragen eines differentiellen Signals weist das Innenleiterteil des HF-Steckverbinders zwei Signalleiter auf.

In einer beispielhaften Ausführungsform ist die Abschirmhülse als tunnelartige Ausstülpung des Gehäuses ausgebildet.

In einer beispielhaften Ausführungsform umfasst die Abschirmhülse wenigstens ein erstes U-förmiges Bauteil sowie wenigstens eine auf einer von dem ersten U-förmigen Bauteil abgewandten Seite der Leiterplatte aufgebrachte Metallisierung, wobei das erste U-förmige Bauteil über durch die Leiterplatte hindurch gehende erste Durchkontaktierungen mit der ersten Metallisierung verbunden ist. Die Leiterplatte weist beispielsweise auf einer Seite wenigstens eine zweite Metallisierung auf, welche eine Systemmasse der Leiterplatte ausbildet und galvanisch von der ersten Metallisierung getrennt ist. Das Außenleiterteil des HF-Steckverbinders ist dabei bevorzugt wenigstens teilweise von wenigstens einem zweiten U-förmigen Bauteil sowie wenigstens einer in der Leiterplatte ausgebildeten Metallschicht ausgebildet, wobei das zweite U-förmige Bauteil über in der Leiterplatte angeordnete Durchkontaktierungen mit der Metallschicht verbunden ist und wobei die Metallschicht in der Leiterplatte derart angeordnet ist, dass diese zwischen der ersten Metallisierung und dem ersten U-förmigen Bauteil der Abschirmhülse angeordnet ist.

In einer alternativen Ausführungsform umfasst die Abschirmhülse wenigstens zwei erste U-förmige Bauteile, die an gegenüberliegenden Seiten der Schaltungsplatine angeordnet sind, wobei die ersten U-förmigen Bauteile über durch die Leiterplatte hindurch gehende erste Durchkontaktierungen miteinander verbunden ist. Das Außenleiterteil des HF-Steckverbinders ist wenigstens teilweise von wenigstens einem zweiten U-förmigen Bauteil sowie wenigstens einer in der Leiterplatte ausgebildeten Metallschicht ausgebildet, wobei das zweite U-förmige Bauteil über in der Leiterplatte angeordnete zweite Durchkontaktierungen mit der Metallschicht verbunden ist und wobei die Metallschicht in der Leiterplatte derart angeordnet ist, dass diese zwischen den ersten U-förmigen Bauteilen der Abschirmhülse angeordnet ist. Die Leiterplatte weist auf einer Seite wenigstens eine zweite Metallisierung auf, weiche eine Systemmasse der Leiterplatte ausbildet und galvanisch von den ersten U-förmigen Bauteilen getrennt ist.

Zweckmäßigerweise ist der HF-Steckverbinder an einem von der Leiterplatte abgewandten, aus dem Gehäuse heraus ragenden Ende zum Verbinden mit einem Steckverbinder eines Signalkabels ausgebildet.

Die Erfindung wird im Folgenden anhand der Zeichnung näher erläutert. Diese zeigt in:
- Fig. 1: eine erste bevorzugte Ausführungsform einer erfindungsgemäßen Schaltungsanordnung in schematischer Schnittansicht,
- Fig. 2: eine zweite bevorzugte Ausführungsform einer erfindungsgemäßen Schaltungsanordnung in perspektivischer Schnittansicht,
- Fig. 3: die zweite bevorzugte Ausführungsform einer erfindungsgemäßen Schaltungsanordnung gemäß Fig. 2 in einer weiteren perspektivischen Schnittansicht,
- Fig. 4: die zweite bevorzugte Ausführungsform einer erfindungsgemäßen Schaltungsanordnung gemäß Fig. 2 in einer weiteren perspektivischen Schnittansicht ohne Leiterplatte,
- Fig. 5: die zweite bevorzugte Ausführungsform einer erfindungsgemäßen Schaltungsanordnung gemäß Fig. 2 in einer weiteren perspektivischen Schnittansicht ohne Leiterplatte und ohne Innenleiterteil,
- Fig. 6: eine dritte bevorzugte Ausführungsform einer erfindungsgemäßen Schaltungsanordnung in perspektivischer Schnittansicht,
- Fig. 7: die dritte bevorzugte Ausführungsform einer erfindungsgemäßen Schaltungsanordnung gemäß Fig. 6 in einer weiteren perspektivischen Schnittansicht ohne Leiterplatte,
- Fig. 8: die dritte bevorzugte Ausführungsform einer erfindungsgemäßen Schaltungsanordnung gemäß Fig. 6 in einer weiteren perspektivischen Schnittansicht ohne Leiterplatte und ohne einen oberen Teil einer Abschirmhülse und
- Fig. 9: die dritte bevorzugte Ausführungsform einer erfindungsgemäßen Schaltungsanordnung gemäß Fig. 6 in einer weiteren perspektivischen Schnittansicht ohne Leiterplatte und ohne einen oberen Teil einer Abschirmhülse.

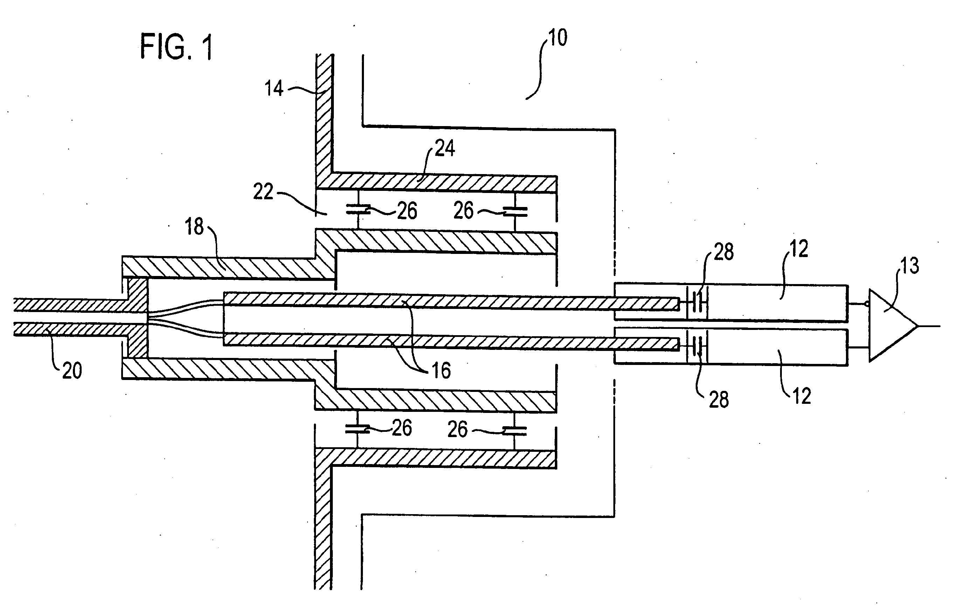

Die in Fig. 1 dargestellte, erste bevorzugte Ausführungsform einer erfindungsgemäßen Schaltungsanordnung umfasst eine Leiterplatte 10 mit einer elektronischen Schaltung aus entsprechenden Leiterbahnen und Bauteilen, von der lediglich zwei auf der Leiterplatte 10 angeordnete Signalleiterbahnen 12 sowie ein Verstärkerbauteil 13 dargestellt sind, ein abschirmendes Gehäuse 14 und einen HF-Steckverbinder, welcher ein Innenleiterteil 16 und ein Außenleiterteil 18 aufweist. Der HF-Steckverbinder ist in der dargestellten, beispielhaften Ausführungsform für die Übertragung von differentiellen Signalen mit zwei Signalleitern und zum Verbinden mit einem entsprechenden Signalkabel 20 ausgebildet. Der HF-Steckverbinder erstreckt sich durch eine Öffnung 22 in dem Gehäuse 14. Für die abschirmende Funktion des Gehäuses ist dieses aus einem entsprechenden, elektrisch leitfähigen Werkstoff, insbesondere Metall, ausgebildet. Die Leiterplatte 10 weist eine Systemmasse auf, die galvanisch von dem Gehäuse getrennt ist. Das Innenleiterteil 16 ist beispielsweise mittels Kondensatoren 28 kapazitiv mit den Signalleiterbahnen 12 verbunden.

Das Außenleiterteil 18 ist galvanisch von dem Gehäuse 14 getrennt, d.h. der HF-Steckverbinder erstreckt sich durch die Öffnung 22 ohne dass das Außenleiterteil 18 einen direkten elektrischen (galvanischen) Kontakt zum Gehäuse 14 hat. Erfindungsgemäß ist das Gehäuse 14 im Bereich der Öffnung 22 tunnelartig zu einer Abschirmhülse 24 eingezogen und der HF-Steckverbinder erstreckt sich durch die Abschirmhülse 24 hindurch. Hierbei ist die Abschirmhülse 24 über Kondensatoren 26 an voneinander beabstandeten Stellen mit dem Außenleiterteil 18 des HF-Steckverbinders kapazitiv verbunden. Auf diese Weise sind Gleichströme von dem Außenleiterteil 18 zu dem Gehäuse 14 bzw. der Abschirmhülse 24 unterbunden, wobei gleichzeitig hochfrequente Signale über die Kondensatoren kurzgeschlossen sind. Auch Moden höherer Ordnung können den durch die Abschirmhülse 24 ausgebildeten Tunnel nicht überwinden, da diese exponentiell abklingen. Insgesamt ist somit die Öffnung 22 trotz des mechanische bestehenden Zwischenraumes zwischen Abschirmhülse 24 und Außenleiterteil 18 undurchdringlich für Hochfrequenzsignale, so dass weder aus dem inneren des Gehäuses HF nach außen dringen oder von außen HF in das Gehäuse eindringen kann.

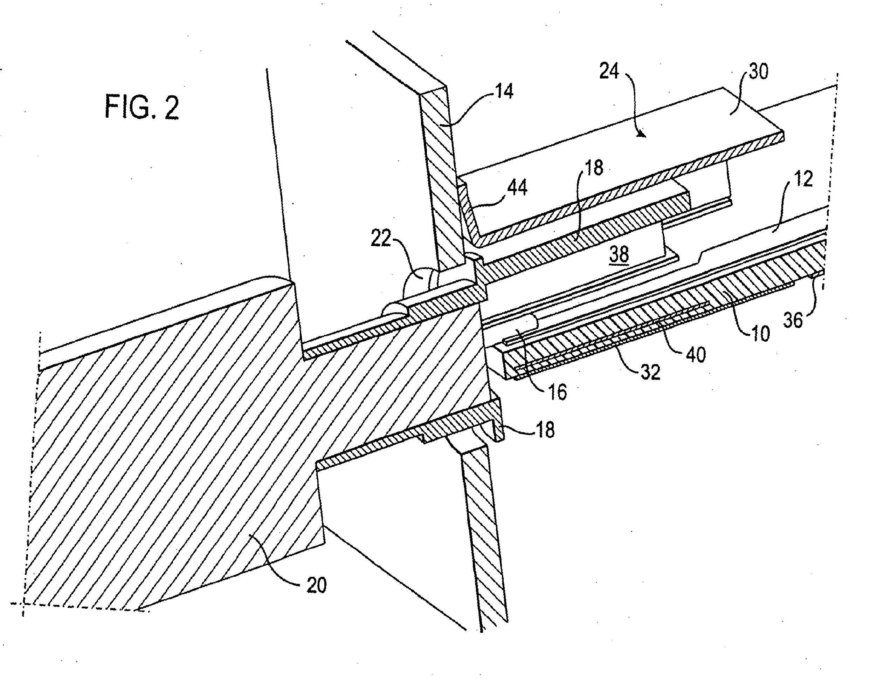

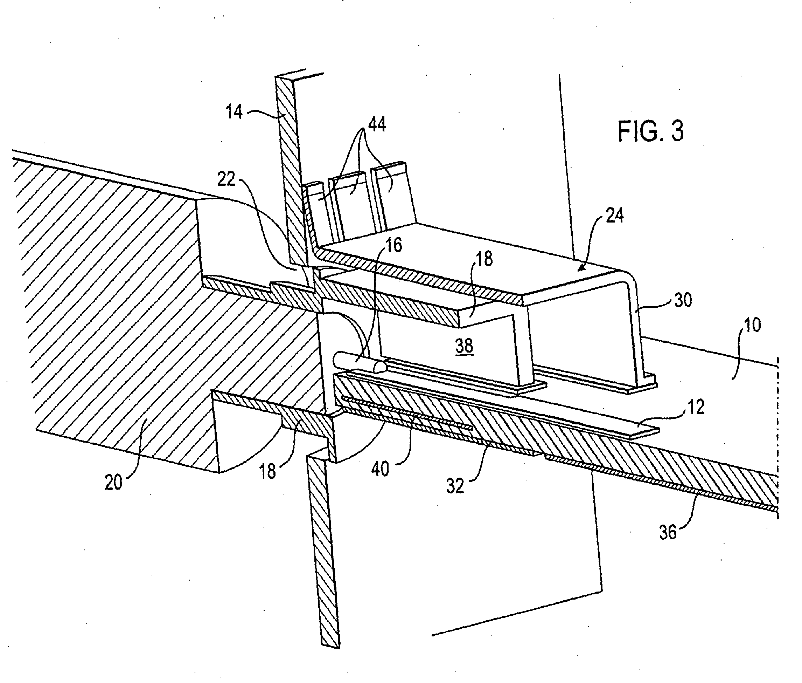

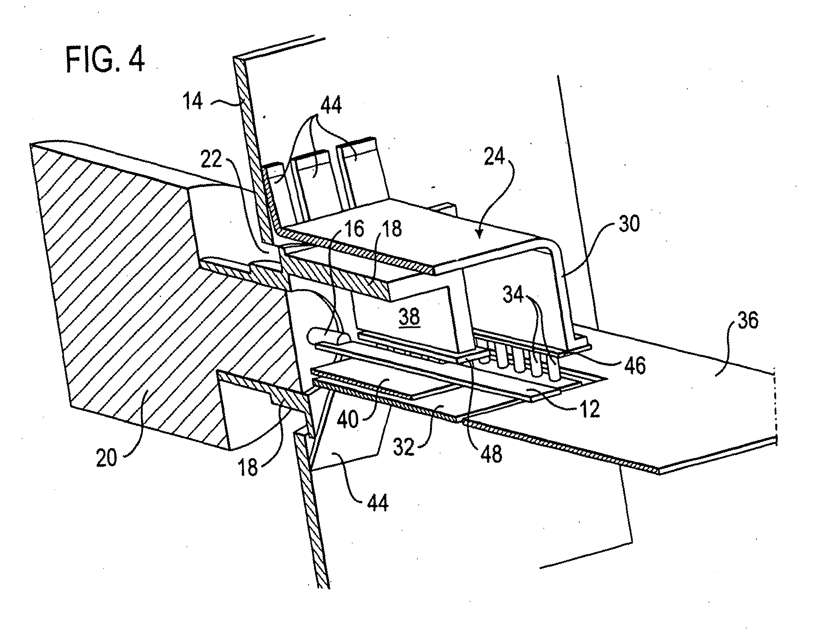

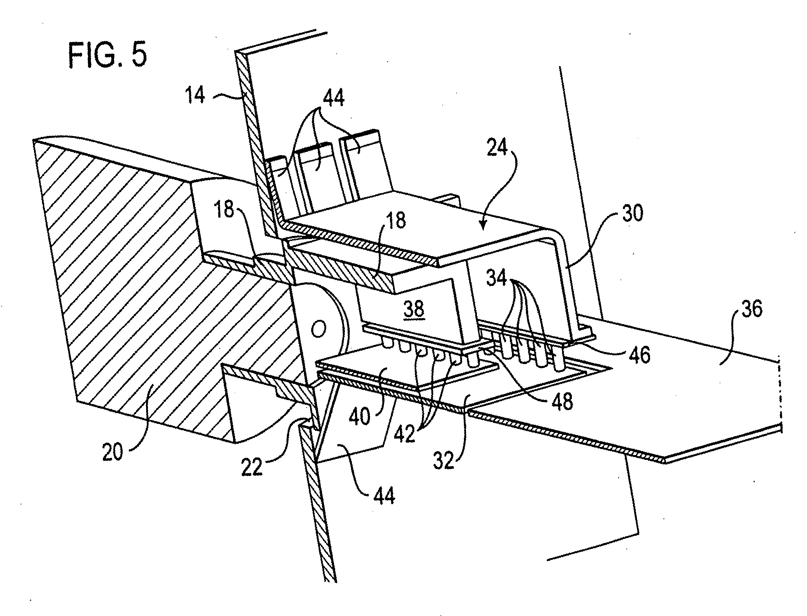

Eine zweite bevorzugte Ausführungsform der erfindungsgemäßen Schaltungsanordnung ist in den Fig. 2 bis 5 in verschiedenen Ansichten dargestellt, wobei in den Fig. 2 bis 5 funktionsgleiche Teile mit gleichen Bezugszeichen bezeichnet sind wie in Fig. 1, so dass zu deren Erläuterung auf die obige Beschreibung der Fig. 1 verwiesen wird. Weiterhin unterscheiden sich die verschiedenen Ansichten der Fig. 2 bis 5 neben den unterschiedlichen Perspektiven auch dadurch, dass zu besseren Sichtbarkeit von ansonsten verdeckten Bauteilen in den Fig. 4 und 5 die Leiterplatte 10 und in Fig. 5 zusätzlich das Innenleiterteil 16 mit der Signalleiterbahn 12 ausgeblendet sind. In den Fig. 2 bis 5 ist das Signalkabel 20 lediglich schematisch dargestellt. Weiterhin sind aus Gründen der Übersichtlichkeit die Kondensatoren 26, welche das Außenleiterteil 18 mit der Abschirmhülse 24 kapazitiv verbinden, nicht dargestellt.

Wie aus den Fig. 2 bis 5 ersichtlich, ist die Abschirmhülse 24 aus einem ersten U-förmigen Bauteil 30 und einer ersten Metallisierung 32 auf der Leiterplatte 10 ausgebildet, wobei die erste Metallisierung 32 auf einer von dem ersten U-förmigen Bauteil 30 abgewandten Seite der Leiterplatte 10 angeordnet ist. Das erste U-förmige Bauteil 30 und die erste Metallisierung 32 sind über erste Durchkontaktierungen 34 (vgl. Fig. 4 und 5) in der Leiterplatte 10 miteinander elektrisch verbunden. Auf derselben Seite wie die erste Metallisierung 32 ist eine zweite Metallisierung 36 auf der Leiterplatte 10 angeordnet, die die Systemmasse der Leiterplatte 10 ausbildet und galvanisch von der ersten Metallisierung 32 sowie dem Gehäuse 14 getrennt ist. Diese Systemmasse 36 ist auch von dem Außenleiterteil 18 galvanisch getrennt.

Der sich innerhalb der Abschirmhülse 24, 30, 32 befindende Abschnitt des Außenleiterteils 18 ist von einem zweiten U-förmigen Bauteil 38 sowie einer Metallschicht 40 innerhalb der Leiterplatte 10 ausgebildet, wobei in der Leiterplatte 10 zweite Durchkontaktierungen 42 (vgl. Fig. 5) angeordnet sind, die das zweite U-förmige Bauteil 38 und die Metallschicht 40 elektrisch galvanisch miteinander verbinden. Insgesamt ist die Anordnung der Metallschicht 40, des ersten und zweiten U-förmigen Bauteils 30, 38 sowie der ersten Metallisierung 32 derart, dass die von dem ersten U-förmigen Bauteil 30 und der ersten Metallisierung 32 gebildete Abschirmhülse 24 den aus zweitem U-förmigem Bauteil 38 und Metallschicht 40 gebildeten Abschnitt des Außenleiterteils 18 umgibt. Insofern bilden Innenleiterteil 16, Außenleiterteil 18 und Abschirmhülse 24 eine triaxiale Anordnung.

Das erste U-förmige Bauteil 30 der Abschirmhülse 24 ist über federnde Kontaktlaschen 44 direkt elektrisch galvanisch mit dem Gehäuse 14 verbunden. Dagegen sind die Metallschicht 40 und die erste Metallisierung 32 galvanisch voneinander getrennt.

Wie insbesondere aus den Fig. 4 und 5 ersichtlich, sitzen die U-förmigen Bauteile 30 und 38 auf jeweiligen Kontaktfeldern 46 und 48 auf, die wiederum mit den ersten und zweiten Durchkontaktierungen 34 bzw. 42 verbunden sind. Die kapazitive Verbindung zwischen dem Außenleiterteil 18 und der Abschirmhülse 24 erfolgt beispielsweise mittels der in den Fig. 4 und 5 nicht dargestellten Kondensatoren über diese Kontaktfelder 46 und 48, wobei die Kondensatoren dabei jeweils mit einem Ende mit dem Kontaktfeld 46 und mit dem entsprechend anderen Ende mit dem anderen Kontaktfeld 48 verbunden sind. Vorzugsweise sind mehrere Kondensatoren vorgegehen, die in axialer Richtung des HF-Steckverbinders voneinander beabstandet sind.

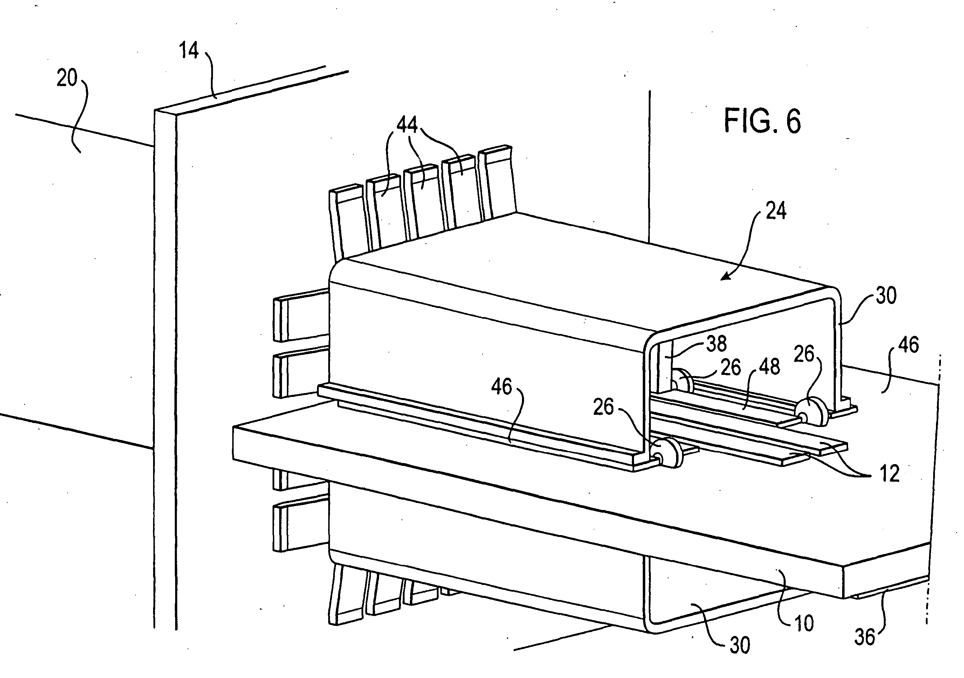

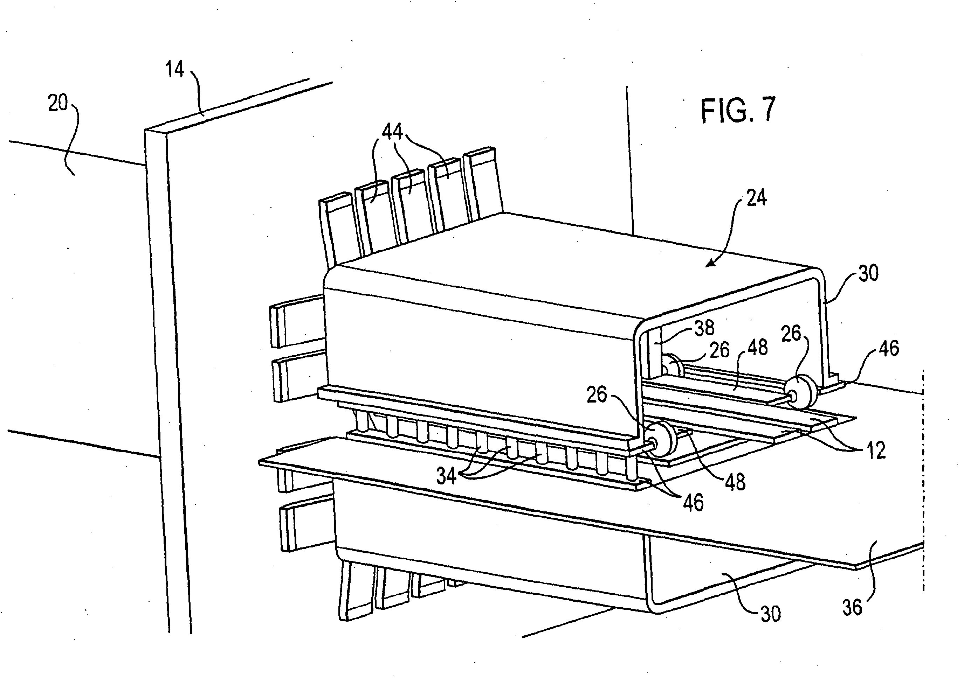

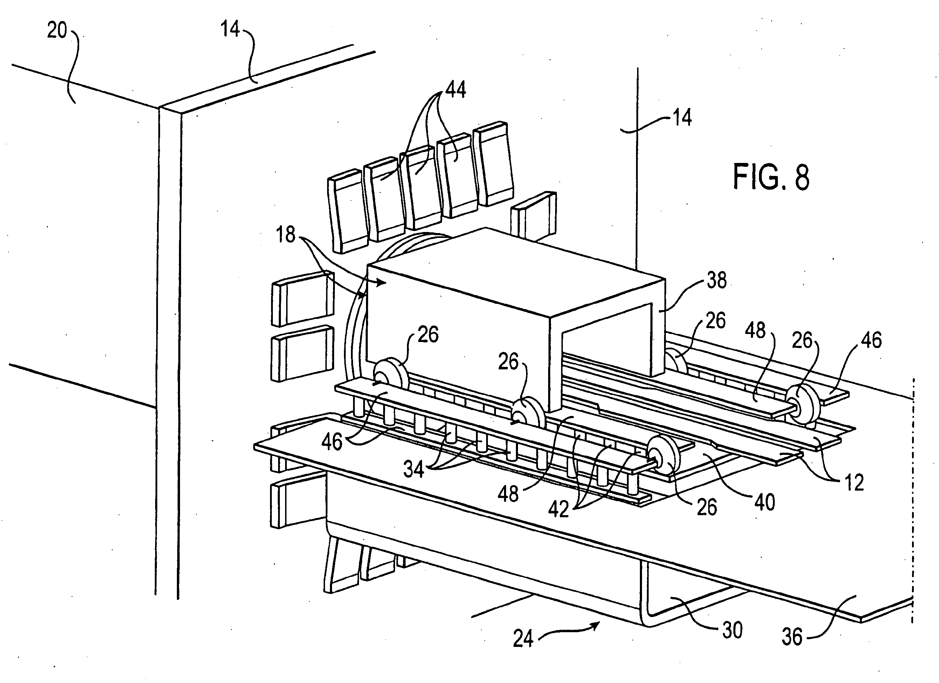

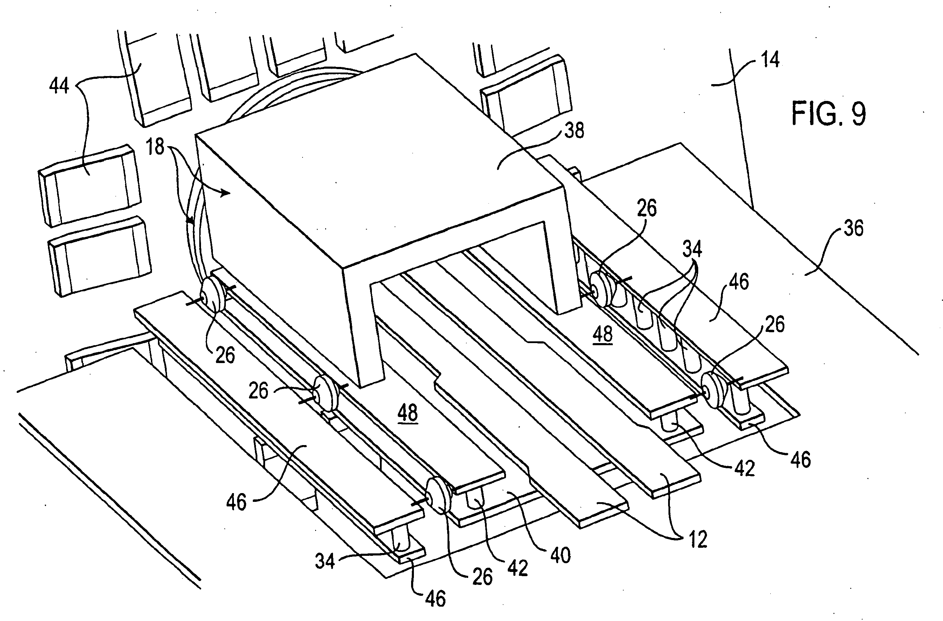

Die Fig. 6 bis 9 zeigen eine dritte bevorzugte Ausführungsform der erfindungsgemäßen Schaltungsanordnung in verschiedenen Ansichten, wobei in den Fig. 6 bis 9 funktionsgleiche Teile mit gleichen Bezugszeichen bezeichnet sind wie in den Fig. 1 bis 5, so dass zu deren Erläuterung auf die obige Beschreibung der Fig. 1 bis 5 verwiesen wird. Im Unterschied zur zweiten bevorzugten Ausführungsform gemäß der Fig. 2 bis 5 ist bei der dritten bevorzugten Ausführungsform die Abschirmhülse aus zwei ersten U-förmigen Bauteilen 30 ausgebildet, die an gegenüberliegenden Seiten der Leiterplatte 10 angeordnet sind. Die Metallisierung 32 gemäß der zweiten Ausführungsform ist nicht vorhanden. Die beiden ersten U-förmigen Bauteile 30 sind über die ersten Durchkontaktierungen 34 (vgl. Fig. 7 bis 9) in der Leiterplatte 10 miteinander elektrisch verbunden. Durch die bzgl. der Leiterplatte 10 beidseitige Anordnung der beiden ersten U-förmigen Bauteilen 30 ergibt sich eine noch höhere Sperrdämpfung.

Das Außenleiterteil 18 ist alternativ mit der Systemmasse 36 galvanisch oder lediglich kapazitiv verbunden. Diese Verbindung kann jedoch vollständig entfallen, wenn über die beiden Signalleiter 12 ein symmetrisches Signal übertragen wird, d.h. ein Signal dessen Summenstrom null ist, so dass keinerlei Strom über die Systemmasse fließt.

Die kapazitive Verbindung zwischen dem Außenleiterteil 18 und der Abschirmhülse 24 kann mittels vier, sechs, acht oder mehr voneinander beabstandeten Kondensatoren 26 erfolgen. Diese sind in den dargestellten Ausführungsformen paarweise angeordnet, dies muss jedoch nicht notwendigerweise so sein. Vorzugsweise bilden die Kondensatoren 26 eine verteilte Struktur, die elektrisch wie ein Tiefpass wirkt.

## Patentansprüche

1. Schaltungsanordnung mit einer auf einer Leiterplatte (10) angeordneten elektronischen Schaltung (12, 13) und einem die Leiterplatte (10) umgebenden, elektrisch abschirmenden Gehäuse (14), wobei auf der Leiterplatte (10) ein mit der elektronischen Schaltung (12, 13) verbundener HF-Steckverbinder mit einem Außenleiterteil (18) und einem Innenleiterteil (16) angeordnet ist, wobei der HF-Steckverbinder durch eine Öffnung (22) in dem Gehäuse (14) hindurch greift,
**dadurch gekennzeichnet,**
**dass** das Außenleiterteil (18) des HF-Steckverbinders von dem Gehäuse (14) galvanisch getrennt ist, wobei eine das Außenleiterteil (18) sowohl in axialer Richtung als auch in Umfangsrichtung wenigstens teilweise tunnelartig umgebende Abschirmhülse (24) angeordnet ist, welche mit dem Gehäuse (14) galvanisch und mit dem Außenleiterteil (18) des HF-Steckverbinders kapazitiv verbunden ist.

2. Schaltungsanordnung nach Anspruch 1, **dadurch gekennzeichnet, dass** die Leiterplatte (10) eine Systemmasse (36) aufweist, die von dem Gehäuse (14) galvanisch getrennt ist.

3. Schaltungsanordnung nach wenigstens einem der vorhergehenden Ansprüche, **dadurch gekennzeichnet, dass** das Innenleiterteil (16) mit wenigstens einer Signalleiterbahn (12) der elektronischen Schaltung auf der Leiterplatte (10) galvanisch oder kapazitiv verbunden ist.

4. Schaltungsanordnung nach wenigstens einem der vorhergehenden Ansprüche, **dadurch gekennzeichnet, dass** die kapazitive Verbindung zwischen der Abschirmhülse (24) und dem Außenleiterteil (18) des HF-Steckverbinders mehrere Kondensatoren (26) umfasst, die beabstandet voneinander jeweils einerseits mit der Abschirmhülse (24) und andererseits mit dem Außenleiterteil (18) des HF-Steckverbinders verbunden sind.

5. Schaltungsanordnung nach wenigstens einem der vorhergehenden Ansprüche, **dadurch gekennzeichnet, dass** das Innenleiterteil (16) des HF-Steckverbinders zwei Signalleiter aufweist.

6. Schaltungsanordnung nach wenigstens einem der vorhergehenden Ansprüche, **dadurch gekennzeichnet, dass** die Abschirmhülse (24) als tunnelartige Ausstülpung des Gehäuses (14) ausgebildet ist.

7. Schaltungsanordnung nach wenigstens einem der Ansprüche 1 bis 5, **dadurch gekennzeichnet, dass** die Abschirmhülse (24) wenigstens ein erstes U-förmiges Bauteil (30) sowie wenigstens eine auf einer von dem ersten U-förmigen Bauteil (30) abgewandten Seite der Leiterplatte (10) aufgebrachte erste Metallisierung (32) umfasst, wobei das erste U-förmige Bauteil (30) über durch die Leiterplatte (10) hindurch gehende erste Durchkontaktierungen (34) mit der ersten Metallisierung (32) verbunden ist.

8. Schaltungsanordnung nach Anspruch 7, **dadurch gekennzeichnet, dass** die Leiterplatte (10) auf einer Seite wenigstens eine zweite Metallisierung (36) aufweist, welche eine Systemmasse der Leiterplatte (10) ausbildet und galvanisch von der ersten Metallisierung (32) getrennt ist.

9. Schaltungsanordnung nach Anspruch 7 oder 8, **dadurch gekennzeichnet, dass** das Außenleiterteil (18) des HF-Steckverbinders wenigstens teilweise von wenigstens einem zweiten U-förmigen Bauteil (38) sowie wenigstens einer in der Leiterplatte (10) ausgebildeten Metallschicht (40) ausgebildet ist, wobei das zweite U-förmige Bauteil (38) über in der Leiterplatte (10) angeordnete zweite Durchkontaktierungen (42) mit der Metallschicht (40) verbunden ist und wobei die Metallschicht (40) in der Leiterplatte (10) derart angeordnet ist, dass diese zwischen der ersten Metallisierung (32) und dem ersten U-förmigen Bauteil (30) der Abschirmhülse (24) angeordnet ist.

10. Schaltungsanordnung nach wenigstens einem der Ansprüche 1 bis 5, **dadurch gekennzeichnet, dass** die Abschirmhülse (24) wenigstens zwei erste U-förmige Bauteile (30) umfasst, die an gegenüberliegenden Seiten der Schaltungsplatine angeordnet sind, wobei die ersten U-förmigen Bauteile (30) über durch die Leiterplatte (10) hindurch gehende erste Durchkontaktierungen (34) miteinander verbunden ist.

11. Schaltungsanordnung nach Anspruch 10, **dadurch gekennzeichnet, dass** das Außenleiterteil (18) des HF-Steckverbinders wenigstens teilweise von wenigstens einem zweiten U-förmigen Bauteil. (38) sowie wenigstens einer in der Leiterplatte (10) ausgebildeten, Metallschicht (40) ausgebildet ist, wobei das zweite U-förmige Bauteil (38) über in der Leiterplatte (10) angeordnete zweite Durchkontaktierungen (42) mit der Metallschicht (40) verbunden ist und wobei die Metallschicht (40) in der Leiterplatte (10) derart angeordnet ist, dass diese zwischen den ersten U-förmigen Bauteilen (30) der Abschirmhülse (24) angeordnet ist.

12. Schaltungsanordnung nach Anspruch 10 oder 11, **dadurch gekennzeichnet, dass** die Leiterplatte (10) auf einer Seite wenigstens eine zweite Metallisierung (36) aufweist, welche eine Systemmasse der Leiterplatte (10) ausbildet und galvanisch von den ersten U-förmigen Bauteilen (30) getrennt ist.

13. Schaltungsanordnung nach wenigstens einem der vorhergehenden Ansprüche, **dadurch gekennzeichnet, dass** der HF-Steckverbinder an einem von der Leiterplatte (10) abgewandten, aus dem Gehäuse (14) heraus ragenden Ende zum Verbinden mit einem Steckverbinder eines Signalkabels (20) ausgebildet ist.

## Claims

1. Circuit arrangement having an electronic circuit (12, 13) arranged on a printed circuit board (10) and having a housing (14) which surrounds and electrically screens the printed circuit board (10), there being arranged on the printed circuit board (10) an HF plug or socket connector which is connected to the electronic circuit (12, 13) and which has an outer-conductor part (18) and a centre-conductor part (16), with the HF plug or socket connector passing through an opening (22) in the housing (14), **characterised in that** the outer-conductor part (18) of the HF plug or socket connector is isolated from the housing (14) by not being directly connected thereto, a screening sleeve (24) being provided which at least partly surrounds the outer-conductor part (18) in a tunnel-like form both in the axial direction and also in the circumferential direction and which is directly connected to the housing (14) and which is capacitively connected to the outer-conductor part (18) of the HF plug or socket connector.

2. Circuit arrangement according to claim 1, **characterised in that** the printed circuit board (10) has a system earth (36) which is isolated from the housing (10) by not being directly connected thereto.

3. Circuit arrangement according to at least one of the foregoing claims, **characterised in that** the centre-conductor part (16) is directly or capacitively connected to at least one printed signal conductor (12) of the electrical circuit on the printed-circuit board (10).

4. Circuit arrangement according to at least one of the foregoing claims, **characterised in that** the capacitive connection between the screening sleeve (24) and the outer-conductor part (18) of the HF plug or socket connector comprises a plurality of capacitors (26) which are each connected on the one hand to the screening sleeve (24) and on the other hand to the outer-conductor part (18) of the HF plug or socket connector while being spaced away from one another.

5. Circuit arrangement according to at least one of the foregoing claims, **characterised in that** the centre-conductor part (16) of the HF plug or socket connector has two signal conductors.

6. Circuit arrangement according to at least one of the foregoing claims, **characterised in that** the screening sleeve (24) is in the form of a tunnel-like folding-round of the housing (14).

7. Circuit arrangement according to at least one of claims 1 to 5, **characterised in that** the screening sleeve (24) comprises at least one first U-shaped component (30) and at least one first metallisation (32) which is applied to a side of the printed circuit board (10) which is remote from the first U-shaped component (30), the first U-shaped component (30) being connected to the first metallisation (32) by first through-contacts (34) which pass through the printed circuit board (10).

8. Circuit arrangement according to claim 7, **characterised in that** the printed circuit board (10) has, on one side, at least one second metallisation (32) which forms the system earth of the printed circuit board (10) and which is isolated from the first metallisation (32) by not being directly connected thereto.

9. Circuit arrangement according to claim 7 or 8, **characterised in that** the outer-conductor part (18) of the HF plug or socket connector is at least partly formed by at least one second U-shaped component (38) and at least one metal layer (40) formed in the printed circuit board (10), the second U-shaped component (38) being connected to the metal layer (40) by through-contacts (42) arranged in the printed circuit board (10) and the metal layer (40) being so arranged in the printed circuit board (10) that it is arranged between the first metallisation (32) and the first U-shaped component (30) of the screening sleeve (24).

10. Circuit arrangement according to at least one of claims 1 to 5, **characterised in that** the screening sleeve (24) comprises at least two first U-shaped components (30) which are arranged on opposite sides of the printed circuit board, the first U-shaped components (30) being connected to one another by first through-contacts (34) which pass through the printed circuit board (10).

11. Circuit arrangement according to claim 10, **characterised in that** the outer-conductor part (18) of the HF plug or socket connector is at least partly formed by at least one second U-shaped component (38) and at least one metal layer (40) formed in the printed circuit board (10), the second U-shaped component (38) being connected to the metal layer (40) by second through-contacts (42) arranged in the printed circuit board (10) and the metal layer (40) being so arranged in the printed circuit board (10) that it is arranged between the first U-shaped components (30) of the screening sleeve (24).

12. Circuit arrangement according to claim 10 or 11, **characterised in that** the printed circuit board (10) has, on one side, at least one second metallisation (36) which forms a system earth for the printed circuit board (10) and which is isolated from the first U-shaped components (30) by not being directly connected thereto.

13. Circuit arrangement according to at least one of the foregoing claims, **characterised in that,** at an end which is remote from the printed circuit board (10) and which projects out of the housing (14), the HF plug or socket connector is designed for connection to a plug or socket connector on a signal cable (20).

## Revendications

1. Agencement de circuit comprenant un circuit électronique (12, 13) agencé sur une carte à circuits imprimés (10) et un boîtier (14) formant écran électrique qui entoure la carte à circuits imprimés (10), dans lequel un connecteur enfichable HF comprenant une partie conductrice extérieure (18) et une partie conductrice intérieure (16) et relié au circuit électronique (12, 13) est agencé sur la carte à circuits imprimés (10), le connecteur enfichable HF passant à travers une ouverture (22) dans le boîtier (14),
**caractérisé en ce que** la partie conductrice extérieure (18) du connecteur enfichable HF est séparée du boîtier (14) sur le plan électrique, et une douille-écran (24) qui entoure la partie conductrice extérieure (18) au moins partiellement à la manière d'un tunnel aussi bien en direction axiale qu'en direction périphérique est agencée, ladite douille étant reliée électriquement au boîtier (14) et reliée de manière capacitive à la partie conductrice extérieure (18) du connecteur enfichable HF.

2. Agencement de circuit selon la revendication 1, **caractérisé en ce que** la carte à circuits imprimés (10) comprend une masse système (36) qui est électriquement séparée du boîtier (14).

3. Agencement de circuit selon l'une au moins des revendications précédentes, **caractérisé en ce que** la partie conductrice intérieure (16) est reliée électriquement ou de manière capacitive à au moins une piste conductrice de signaux (12) du circuit électronique sur la carte à circuits imprimés (10).

4. Agencement de circuit selon l'une au moins des revendications précédentes, **caractérisé en ce que** la liaison capacitive entre la douille-écran (24) et la partie conductrice extérieure (18) du connecteur enfichable HF comprend plusieurs condensateurs (26), lesquels sont prévus respectivement à distance les uns des autres et sont connectés d'une part à la douille-écran (24) et d'autre part à la partie conductrice extérieure (18) du connecteur enfichable HF.

5. Agencement de circuit selon l'une au moins des revendications précédentes, **caractérisé en ce que** la partie conductrice intérieure (16) du connecteur enfichable HF comprend deux lignes à signaux.

6. Agencement de circuit selon l'une au moins des revendications précédentes, **caractérisé en ce que** la douille-écran (24) est réalisée sous forme de retroussement semblable à un tunnel dans le boîtier (14).

7. Agencement de circuit selon l'une au moins des revendications 1 à 5, **caractérisé en ce que** la douille-écran (24) comprend au moins premier composant en forme de U (30), ainsi qu'au moins une première métallisation (32) appliquée sur au moins un côté de la carte à circuits imprimés (10), détourné du premier composant en forme de U (30), et le premier composant en forme de U (30) est relié à la première métallisation (32) via des premiers contacts traversants (34) qui traversent la carte à circuits imprimés (10).

8. Agencement de circuit selon la revendication 7, **caractérisé en ce que** la carte à circuits imprimés (10) présente sur un côté au moins une seconde métallisation (36) qui forme une masse système de la carte à circuits imprimés (10) et qui est séparée sur le plan électrique par rapport à la première métallisation (32).

9. Agencement de circuit selon la revendication 7 ou 8, **caractérisé en ce que** la partie conductrice extérieure (18) du connecteur enfichable HF est réalisée au moins partiellement par au moins un second composant en forme de U (38) et par au moins une couche métallique (40) réalisée dans la carte à circuits imprimés (10), dans lequel le second composant en forme de U (38) est relié à la couche métallique (40) via des seconds contacts traversants (42) ménagés dans la carte à circuits imprimés (10), et dans lequel la couche métallique (40) dans la carte à circuits imprimés (10) est agencée de telle manière que celle-ci est agencée entre la première métallisation (32) et le premier composant (30) en forme de U de la douille-écran (24).

10. Agencement de circuit selon l'une au moins des revendications 1 à 5, **caractérisé en ce que** la douille-écran (24) comprend au moins deux composants (30) en forme de U, qui sont agencés sur des côtés opposés de la plaque à circuits, de sorte que les premiers composant en forme de U (30) sont reliés les uns aux autres via les premiers contacts traversants (34) qui traversent la carte à circuits imprimés (10).

11. Agencement de circuit selon la revendication 10, **caractérisé en ce que** la partie conductrice extérieure (18) du connecteur enfichable HF est réalisée au moins partiellement par au moins un second composant en forme de U (38), et au moins par une couche métallique (40) réalisée dans la carte à circuits imprimés (10), de sorte que le second composant en forme de U (38) est relié à la couche métallique (40) via les seconds contacts traversants (42) agencés dans la carte à circuits imprimés (10), et dans lequel la couche métallique (40) est agencé dans la carte à circuits imprimés (10) de telle manière que celle-ci est agencée entre les premiers composants en forme de U (30) de la douille-écran (24).

12. Agencement de circuit selon la revendication 10 ou 11, **caractérisé en ce que** la carte à circuits imprimés (10) comporte sur un côté au moins une seconde métallisation (36) qui constitue une masse système de la carte à circuits imprimés (10) et qui est séparée sur le plan électrique vis-à-vis des premiers composants en forme de U (30).

13. Agencement de circuit selon l'une au moins des revendications précédentes, **caractérisé en ce que** le connecteur enfichable HF est réalisé, à son extrémité détournée de la carte à circuits imprimés (10) et dépassant hors du boîtier (14), en vue de la liaison avec un connecteur enfichable d'un câble à signaux (20).
